# EUROPEAN PATENT APPLICATION

(11) **EP 2 632 234 A1**
(43) Date of publication of application: **28.08.2013**
(21) Application number: 12193205.7
(22) Date of filing: 19.11.2012
(51) Int. Cl.: H05K 1/02, H05K 1/11

(54) **Multilayer wiring board and electronic device**

(30) Priority: 21.02.2012 JP 2012035359
(71) Applicant: FUJITSU LIMITED, Kawasaki-shi, Kanagawa 211-8588 (JP)
(72) Inventor: Kawai, Kenichi, Kanagawa, 211-8588 (JP)
(74) Representative: HOFFMANN EITLE

(57) **Abstract**

A multilayer wiring board includes: a first differential wiring (30A) wired to a third signal layer (3C); and a second differential wiring (30B) wired to a ninth signal layer (3I). The multilayer wiring board includes a first differential signal via (12A) and a second differential signal via (12B) that are connected to the first differential wiring. The multilayer wiring board includes a third differential signal via (12C) which is connected to the second differential wiring and a stub (41) of which is terminated above the third signal layer. The multilayer wiring board includes a fourth differential signal via (12D) which is connected to the second differential wiring and a stub of which is terminated above the third signal layer, the first differential wiring wired to pass between the fourth differential signal via and the third differential signal via.

## Description

### FIELD

The embodiments discussed herein are related to a multilayer wiring board and an electronic device.

### BACKGROUND

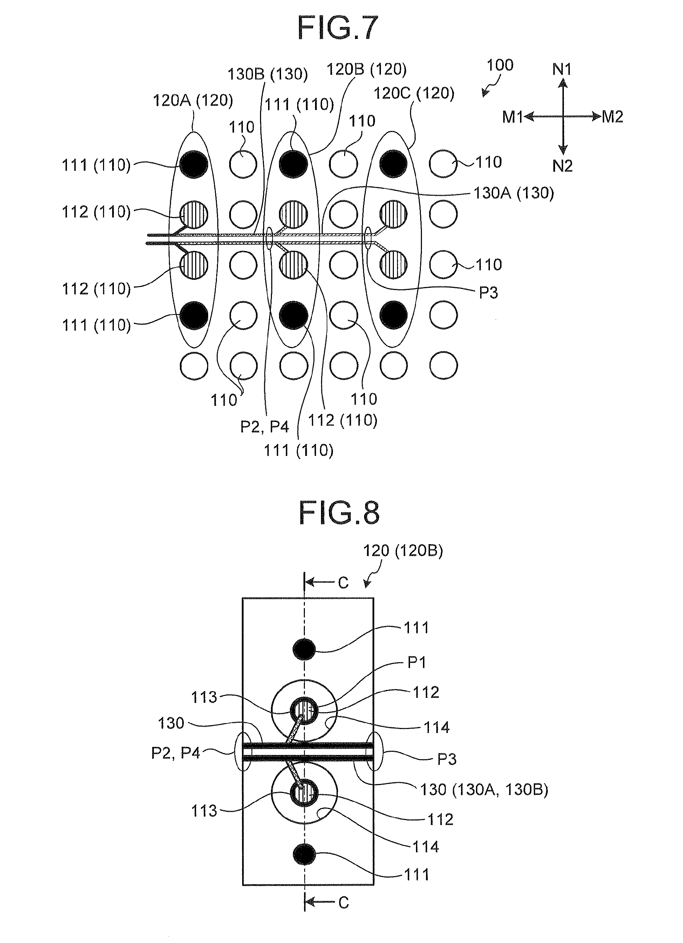

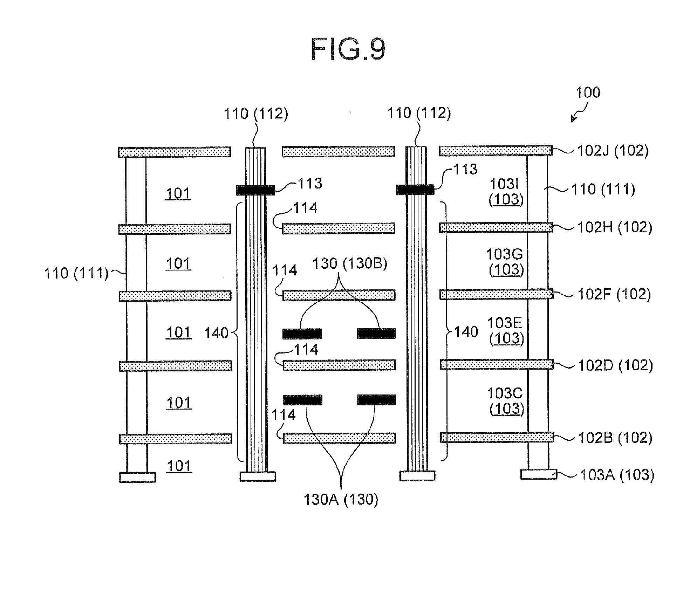

There has been a technology to connect each layer in a multilayer wiring board by a via in the related art. FIG. 7 is an explanatory view illustrating an example of an arrangement relationship of signal via pairs in the multilayer wiring board with a part omitted, FIG. 8 is an explanatory view illustrating an example of the signal via pairs, and FIG. 9 is a cross-sectional view taken along line C-C of FIG. 8 with a part omitted.

A multilayer wiring board 100 illustrated in FIG. 9 has a multilayer structure formed by sequentially laminating a plurality of ground layers 102 and signal layers 103 by using an insulating material 101. For example, each layer is laminated on a first signal layer 103A of the multilayer wiring board 100 in the order of a second ground layer 102B, a third signal layer 103C, a fourth ground layer 102D, a fifth signal layer 103E, a sixth ground layer 102F, and a seventh signal layer 103G. Moreover, each of an eighth ground layer 102H, a ninth signal layer 103I, a tenth ground layer 102J and the like is laminated on the seventh signal layer 103G of the multilayer wiring board 100 in this order.

Vias 110 are formed on a laminating surface of the multilayer wiring board 100 in a grid pattern at a predetermined pitch by filling holes extending in a direction perpendicular to the laminating surface with a conductive substance such as copper. Each of the layers in the multilayer wiring board 100 is then connected by each via 110.

The plurality of vias 110 also includes a ground via 111 and a differential signal via 112. The ground via 111 is connected to the ground layer 102. The differential signal via 112 is connected to the signal layer 103 through a signal land 113. For the convenience of explanation, a black circle indicates the ground via 111 and a hatched circle indicates the differential signal via 112 in FIG. 7.

In addition, a signal via pair 120 includes, for example, a pair of the differential signal vias 112 adjacent in an N1 or an N2 direction, and a pair of the ground vias 111 that interposes the pair of differential signal vias 112 therebetween. Moreover, the signal via pair 120 is connected to a BGA (Ball Grid Array) or an LGA (Land Grid Array), for example. Each signal via pair 120 is disposed while being offset from the adjacent signal via pair 120 by one or two vias, for example.

Moreover, a clearance 114 with a diameter larger than that of the differential signal via 112 is formed in the ground layer 102 through which the differential signal vias 112 in the signal via pair 120 are inserted, the clearance preventing a short circuit between the differential signal vias 112. The clearance 114 is formed in a position not in contact with the differential signal vias 112.

Furthermore, in the multilayer wiring board 100, a differential wiring 130 is disposed in a direction of drawing out a wiring, and this differential wiring 130 is used to draw out the wiring from the differential signal via 112 when the wiring is to be drawn out from the differential signal via 112 of the signal via pair 120.

The multilayer wiring board 100 illustrated in FIG. 7 includes a first signal via pair 120A to a third signal via pair 120C, for example. The multilayer wiring board 100 includes a first differential wiring 130A that draws out a wiring from the differential signal via 112 of the third signal via pair 120C, and a second differential wiring 130B that draws out a wiring from the differential signal via 112 of the second signal via pair 120B. In addition, as illustrated in FIG. 9, the first differential wiring 130A is disposed in the third signal layer 103C between the second ground layer 102B and the fourth ground layer 102D and passes between the differential signal vias 112 in the first signal via pair 120A, for example. Moreover, the second differential wiring 130B is disposed in the fifth signal layer 103E between the fourth ground layer 102D and the sixth ground layer 102F and passes between the differential signal vias 112 in the first signal via pair 120A, for example.
Patent Document 1: Japanese Laid-open Patent Publication No. 60-127797
Patent Document 2: Japanese National Publication of International Patent Application No. 2010-506380
Patent Document 3: Japanese Laid-open Patent Publication No. 2011-18673
Patent Document 4: Japanese Laid-open Patent Publication No. 08-204338
Patent Document 5: Japanese Laid-open Patent Publication No. 2001-119154
Patent Document 6: Japanese Laid-open Patent Publication No. 2004-95614

However, the multilayer wiring board 100 experiences a greater influence of an electromagnetic wave generated between the differential signal vias 112, since the distance between the pair of differential signal vias 112 in the signal via pair 120 has decreased accompanying the request to increase the wiring density in recent years. Besides, the interference of electromagnetic waves between the differential signal vias 112 and the differential wiring 130 causes greater crosstalk when the differential wiring 130 passes between the pair of differential signal vias 112. As a result, a signal of the differential signal vias 112 would be a noise of a signal of the differential wiring 130, and the signal of the differential wiring 130 would be a noise of the signal of the differential signal vias 112.

Furthermore, in the multilayer wiring board 100, the electromagnetic wave that leaks from a stub 140 of the differential signal via 112 affects the adjacent differential wiring 130. In this manner, the greater crosstalk between the differential signal vias 112 and the differential wiring 130 is caused by the signal of the differential signal vias 112 and the signal of the differential wiring 130 being the noise to each other as well as the electromagnetic wave leaking from the stub 140 of the differential signal via 112.

Accordingly, it is an object in one aspect of an embodiment of the invention to provide the multilayer wiring board and an electronic device capable of reducing the crosstalk between the differential signal via (the signal via) and the differential wiring (the differential signal wiring).

### SUMMARY

According to an aspect of the embodiments, a multilayer wiring board includes a plurality of signal layers; a plurality of ground layers; a first differential signal wiring wired to a first signal layer among the plurality of signal layers; a second differential signal wiring wired to a second signal layer disposed above the first signal layer among the plurality of signal layers; a first signal via that extends in a laminating direction of the multilayer wiring board and is connected to the first differential signal wiring; a second signal via that is formed adjacent to the first signal via, extends in the laminating direction, and is connected to the first differential signal wiring; a third signal via that extends in the laminating direction and is connected to the second differential signal wiring, a stub of the third signal via being terminated above the first signal layer; and a fourth signal via that is formed adjacent to the third signal via, extends in the laminating direction, and is connected to the second differential signal wiring, a stub of the fourth signal via being terminated above the first signal layer, the first differential signal wiring being wired to pass between the fourth signal via and the third signal via.

According to another aspect of the embodiments, a multilayer wiring board includes a plurality of signal layers; a plurality of ground layers; a first differential signal wiring wired to a first signal layer among the plurality of signal layers; a second differential signal wiring wired to a second signal layer disposed below the first signal layer among the plurality of signal layers; a first signal via that extends in a laminating direction of the multilayer wiring board and is connected to the first differential signal wiring; a second signal via that is formed adjacent to the first signal via, extends in the laminating direction, and is connected to the first differential signal wiring; a third signal via that extends in the laminating direction and is connected to the second differential signal wiring; and a fourth signal via that is formed adjacent to the third signal via, extends in the laminating direction, and is connected to the second differential signal wiring, the first differential signal wiring being wired to pass between the fourth signal via and the third signal via.

### BRIEF DESCRIPTION OF DRAWINGS

FIG. 1 is an explanatory view illustrating an example of an arrangement relationship of signal via pairs in a multilayer wiring board of Example 1 with a part omitted;
FIG. 2 is a cross-sectional view taken along line A-A of FIG. 1 with a part omitted;
FIGS. 3A to 3D are explanatory views comparing calculation results of crosstalk of Example 1 and Comparative Example 1;
FIG. 4 is an explanatory view illustrating an example of an arrangement relationship of signal via pairs in a multilayer wiring board of Example 2 with a part omitted;
FIG. 5 is a cross-sectional view taken along line B-B of FIG. 4 with a part omitted;
FIG. 6 is an explanatory view illustrating an example of a calculation result of crosstalk of Example 2;
FIG. 7 is an explanatory view illustrating an example of an arrangement relationship of signal via pairs in a multilayer wiring board with a part omitted;
FIG. 8 is an explanatory view illustrating an example of the signal via pairs; and
FIG. 9 is a cross-sectional view taken along line C-C of FIG. 8 with a part omitted.

### DESCRIPTION OF EMBODIMENTS

Preferred embodiments of the present invention will be explained with reference to accompanying drawings.

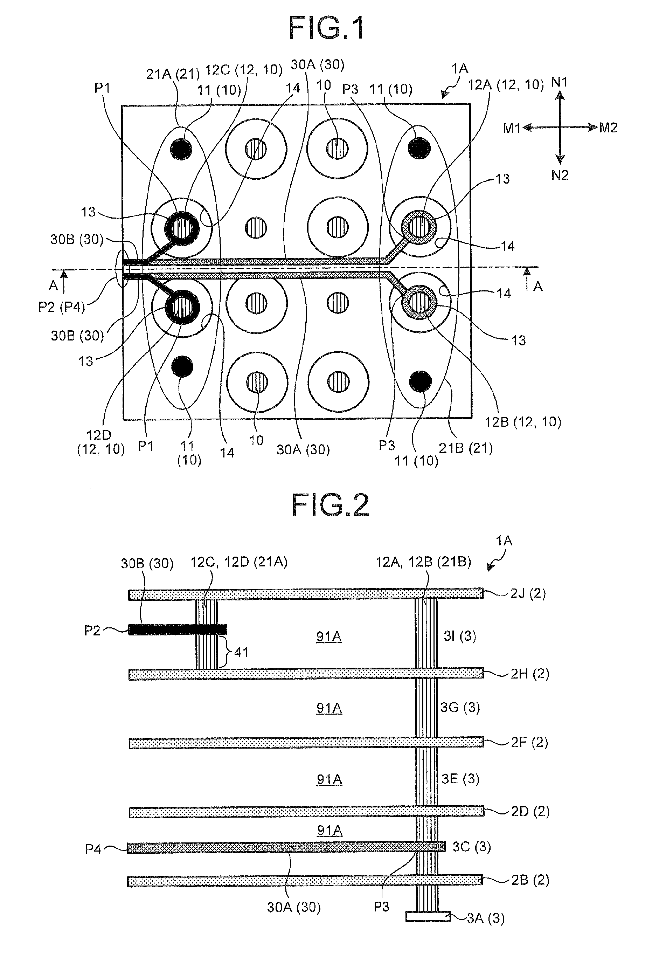

Note that the disclosed technology is not to be limited by the present Example. In Example below, relative positions of each element such as the vias in the multilayer wiring board in two dimensions are illustrated with a vertical direction indicated by the N1 and the N2 facing the figure and a horizontal direction indicated by an M1 and an M2 facing the figure as illustrated in FIG. 1, for example. In Example below, each element such as the signal vias in the multilayer wiring board are disposed in a grid pattern at a predetermined pitch in the M1 and the M2 directions as well as the N1 and the N2 directions. Moreover, in Example below, the diameter of the differential signal via indicates the maximum diameter of a horizontal cross-section of the differential signal via. Furthermore, the diameter of the clearance indicates the maximum diameter of a horizontal cross-section of the clearance.

### [a] Example 1

FIG. 1 is an explanatory view illustrating an example of an arrangement relationship of signal via pairs in a multilayer wiring board of Example 1 with a part omitted. FIG. 2 is a cross-sectional view taken along line A-A of FIG. 1 with a part omitted.

A multilayer wiring board 1A illustrated in FIG. 2 has a multilayer structure such as an 18-layer structure formed by sequentially laminating a plurality of ground layers 2 and signal layers 3 by using an insulating material 91A. For example, each layer is laminated on a first signal layer 3A of the multilayer wiring board 1A in the order of a second ground layer 2B, a third signal layer 3C, a fourth ground layer 2D, a fifth signal layer 3E, a sixth ground layer 2F, and a seventh signal layer 3G. Moreover, each of an eighth ground layer 2H, a ninth signal layer 3I, a tenth ground layer 2J and the like is laminated on the seventh signal layer 3G of the multilayer wiring board 1A in this order. For the convenience of explanation, illustrations from an eleventh layer to an eighteenth layer are omitted. The fourteenth layer, the sixteenth layer and the eighteenth layer are referred to as the signal layers 3, for example.

A via 10 is formed by filling a hole extending in a direction perpendicular to a laminating surface of the ground layer 2 and the signal layer 3 with a conductive substance such as copper. However, the hole does not have to be completely filled as long as it is conducted to the layers connected. Also, the plurality of vias 10 is formed on the laminating surface in a grid pattern at a predetermined pitch, as illustrated in FIG. 1. Each via 10 then connects the layers in the multilayer wiring board 1A.

Moreover, the plurality of vias 10 includes a ground via 11 and a differential signal via 12. The differential signal via 12 is an example of a signal via. The ground via 11 is connected to the ground layer 2. Also, the differential signal via 12 is connected to the signal layer 3 through a signal land 13. For the convenience of explanation, a black circle indicates the ground via 11 and a hatched circle indicates the differential signal via 12 in FIG. 1.

Furthermore, a signal via pair 21 includes, among the plurality of vias 10 disposed in the grid pattern at the predetermined pitch: a pair of the differential signal vias 12 formed by a pair of the vias 10 adjacent in an N1 or an N2 direction illustrated in FIG. 1; and a pair of the adjacent ground vias 11 that interposes both sides of the pair of differential signal vias 12 therebetween. Formed by the vias 10 adjacent to the differential signal vias 12 in the signal via pair 21, the pair of ground vias 11 in the signal via pair 21 can be changed as appropriate. Furthermore, the signal via pair 21 is connected to a BGA (Ball Grid Array) or an LGA (Land Grid Array), for example.

Moreover, a clearance 14 with a diameter larger than that of the differential signal via 12 is formed in the ground layer 2 through which the differential signal vias 12 in the signal via pair 21 are inserted, the clearance 14 preventing a short circuit between the differential signal vias 12. The clearance 14 is formed in a position not in contact with the differential signal vias 12.

Furthermore, a differential wiring 30 is disposed in a direction of drawing out a wiring, and this differential wiring 30 is used to draw out the wiring from the differential signal via 12 when the wiring is to be drawn out from the differential signal via 12 of the signal via pair 21. Note that the differential wiring 30 is an example of a signal wiring.

Furthermore, as illustrated in FIG. 1, the multilayer wiring board 1A includes a first signal via pair 21A disposed on the M1 side of the multilayer wiring board 1A and a second signal via pair 21B disposed on the M2 side of the multilayer wiring board 1A, for example.

Furthermore, the differential signal vias 12 in the first signal via pair 21A include a third differential signal via 12C and a fourth differential signal via 12D. The third differential signal via 12C and the fourth differential signal via 12D are connected to a second differential wiring 30B disposed in the ninth signal layer 3I. The differential signal vias 12 in the second signal via pair 21B include a first differential signal via 12A and a second differential signal via 12B. The first differential signal via 12A and the second differential signal via 12B are connected to a first differential wiring 30A disposed in the third signal layer 3C. The first differential wiring 30A passes between the third differential signal via 12C and the fourth differential signal via 12D in the first signal via pair 21A.

Furthermore, as illustrated in FIG. 2, the third differential signal via 12C and the fourth differential signal via 12D in the first signal via pair 21A are connected to the second differential wiring 30B in the ninth signal layer 3I and extend to the eighth ground layer 2H by means of a stub 41. However, the third and the fourth differential signal vias 12C, 12D and the eighth ground layer 2H are separated by the clearance 14. As a result, the third differential signal via 12C and the fourth differential signal via 12D do not extend to the third signal layer 3C in which the first differential wiring 30A is disposed, the first differential wiring 30A being connected to the first differential signal via 12A and the second differential signal via 12B in the second signal via pair 21B.

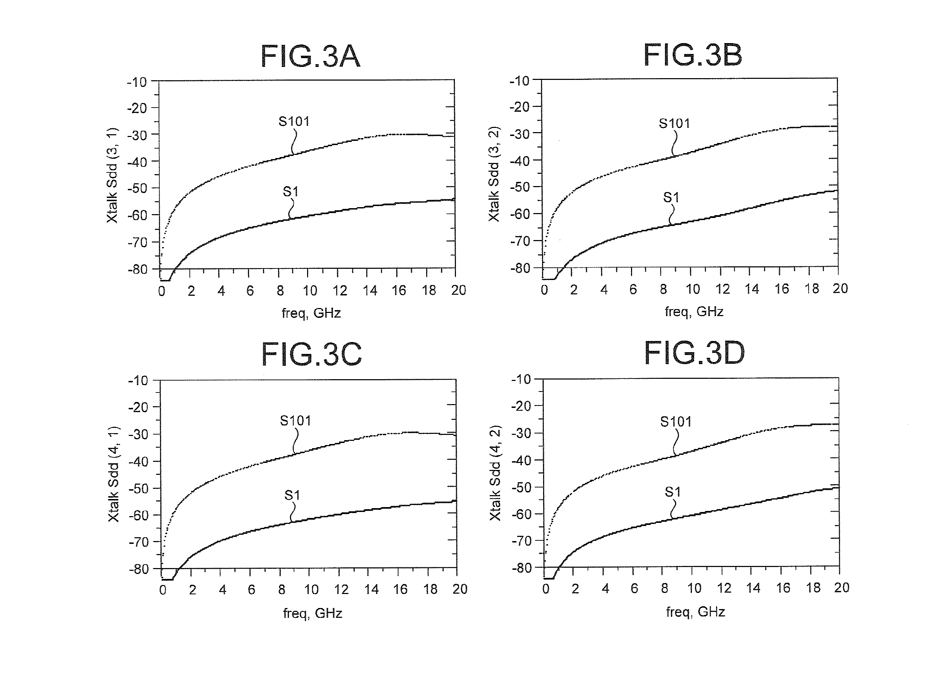

FIGS. 3A to 3D are explanatory views comparing calculation results of crosstalk of Example 1 and Comparative Example 1. A first port P1 is a surface layer (the eighteenth signal layer) of the third differential signal via 12C and the fourth differential signal via 12D in the first signal via pair 21A. A second port P2 is the line terminal on the M1 side of the second differential wiring 30B, as illustrated in FIG. 1. A third port P3 is the line terminal on the M2 side of the first differential wiring 30A connected to the first differential signal via 12A and the second differential signal via 12B in the second signal via pair 21B, as illustrated in FIG. 1. A fourth port P4 is the line terminal on the M1 side of the first differential wiring 30A as illustrated in FIG. 1. Also, in Comparative Example 1, a substrate is used in which the stub 41 of the third differential signal via 12C and the fourth differential signal via 12D in the first signal via pair 21A extends to the third signal layer 3C. These correspond to a second signal via pair 120B and a third signal via pair 120C of FIGS. 7 and 8.

In FIG. 3A, the crosstalk between the first port P1 and the third port P3 is indicated by Xtalk Sdd (3, 1), and the crosstalk between the first port P1 and the fourth port P4 is indicated by Xtalk Sdd (4, 1) in FIG. 3C. Likewise, the crosstalk between the second port P2 and the third port P3 is indicated by Xtalk Sdd (3, 2), and the crosstalk between the second port P2 and the fourth port P4 is indicated by Xtalk Sdd (4, 2).

Referring to FIG. 3A, crosstalk S1 between the first port P1 and the third port P3 of Example 1 is lower by approximately 20 dB than crosstalk S101 between the first port P1 and the third port P3 of Comparative Example 1 in nearly all frequency bands.

Referring to FIG. 3B, the crosstalk S1 between the second port P2 and the third port P3 of Example 1 is lower by approximately 20 dB than the crosstalk S101 between the second port P2 and the third port P3 of Comparative Example 1 in nearly all frequency bands.

Referring to FIG. 3C, the crosstalk S1 between the first port P1 and the fourth port P4 of Example 1 is lower by approximately 20 dB than the crosstalk S101 between the first port P1 and the fourth port P4 of Comparative Example 1 in nearly all frequency bands.

Referring to FIG. 3D, the crosstalk S1 between the second port P2 and the fourth port P4 of Example 1 is lower by approximately 20 dB than the crosstalk S101 between the second port P2 and the fourth port P4 of Comparative Example 1 in nearly all frequency bands.

In Example 1, the third differential signal via 12C and the fourth differential signal via 12D in the first signal via pair 21A are connected to the second differential wiring 30B in the ninth signal layer 3I and extend to the eighth ground layer 2H by means of the stub 41. The third and the fourth differential signal vias 12C, 12D and the eighth ground layer 2H are separated by the clearance 14. Accordingly, the third differential signal via 12C and the fourth differential signal via 12D do not extend to the third signal layer 3C in which the first differential wiring 30A connected to the first differential signal via 12A and the second differential signal via 12B is disposed. As a result, the crosstalk can be reduced between the stub 41 of the third differential signal via 12C and the fourth differential signal via 12D in the first signal via pair 21A and the first differential wiring 30A connected to the second signal via pair 21B.

In Example 1, the stub 41 of the differential signal via 12A (12B) may be shortened to the extent the differential signal via 12C (12D) of the first signal via pair 21A does not extend to the signal layer 3 in which the first differential wiring 30A connected to the differential signal via 12A (12B) of the second signal via pair 21B is disposed. Therefore, the first differential wiring 30A is not limitedly disposed in a specific signal layer 3.

In Example 1, the pair of differential signal vias 12 in the signal via pair 21 is formed by the pair of vias 10 adjacent in the N1 or the N2 direction among the plurality of vias 10 disposed in the grid pattern at the predetermined pitch. However, the pair of differential signal vias 12 may also be formed by the pair of vias 10 adjacent in the M1 or the M2 direction. An embodiment in which the pair of differential signal vias 12 is formed by the pair of vias 10 adjacent in the M1 or the M2 direction will be described below as Example 2.

### [b] Example 2

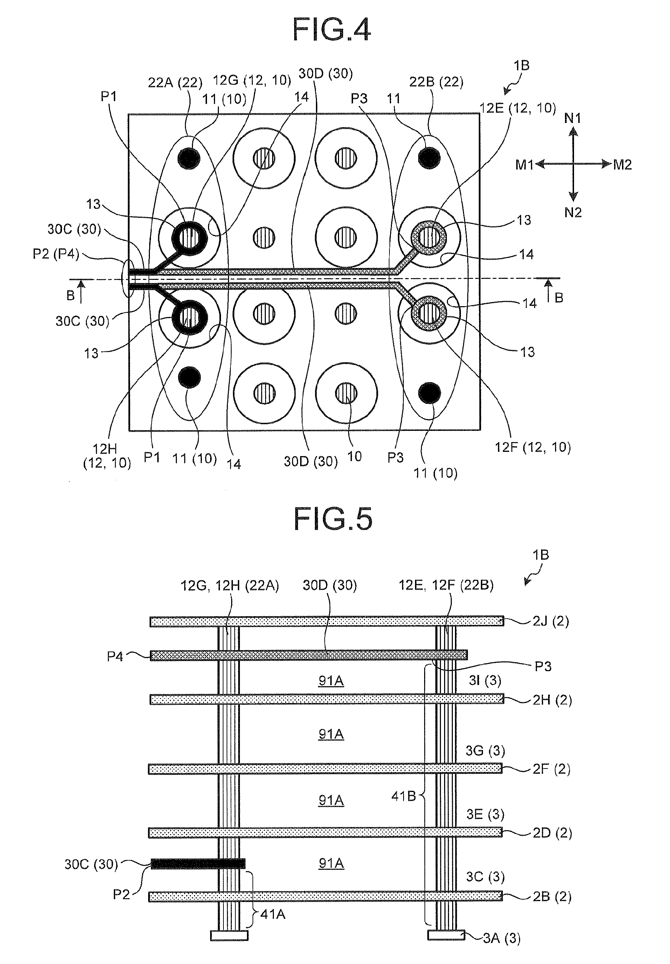

Now, a multilayer wiring board of Example 2 will be described. FIG. 4 is an explanatory view illustrating an example of an arrangement relationship of signal via pairs in a multilayer wiring board of Example 2 with a part omitted. FIG. 5 is a cross-sectional view taken along line B-B of FIG. 4 with a part omitted. Note that components identical to those of the multilayer wiring board 1A of Example 1 are assigned the same reference numerals so that descriptions for the overlapping structure and operation will be omitted.

A signal via pair 22 of a multilayer wiring board 1B illustrated in FIG. 4 includes, among a plurality of vias 10 disposed in a grid pattern at a predetermined pitch: a pair of differential signal vias 12 formed by a pair of the vias 10 adjacent in an N1 or an N2 direction; and a pair of ground vias 11 that interposes both sides of the pair of differential signal vias 12 therebetween. The ground vias 11 can be changed to the vias 10 adjacent to the differential signal vias 12 in the signal via pair 22 as appropriate.

In addition, as illustrated in FIG. 4, the multilayer wiring board 1B includes a first signal via pair 22A disposed on an M1 side of the multilayer wiring board 1B and a second signal via pair 22B disposed on an M2 side of the multilayer wiring board 1B, for example.

Furthermore, the differential signal vias 12 in the first signal via pair 22A include a third differential signal via 12G and a fourth differential signal via 12H. The third differential signal via 12G and the fourth differential signal via 12H are connected to a third differential wiring 30C disposed in a third signal layer 3C. The differential signal vias 12 in the second signal via pair 22B include a first differential signal via 12E and a second differential signal via 12F. The first differential signal via 12E and the second differential signal via 12F are connected to a fourth differential wiring 30D disposed in a ninth signal layer 3I. The fourth differential wiring 30D passes between the third differential signal via 12G and the fourth differential signal via 12H in the first signal via pair 22A.

Furthermore, a stub 41B of the first differential signal via 12E and the second differential signal via 12F in the second signal via pair 22B is longer than a stub 41A of the third differential signal via 12G and the fourth differential signal via 12H in the first signal via pair 22A. As a result, an electromagnetic wave leaks more from the differential signal vias 12E, 12F of the second signal via pair 22B than from the differential signal vias 12G, 12H of the first signal via pair 22A. In the multilayer wiring board 1B of Example 2, the fourth differential wiring 30D connected to the differential signal vias 12E, 12F of the second signal via pair 22B having the long stubs passes between the third differential signal via 12G and the fourth differential signal via 12H of the first signal via pair 22A having the short stubs.

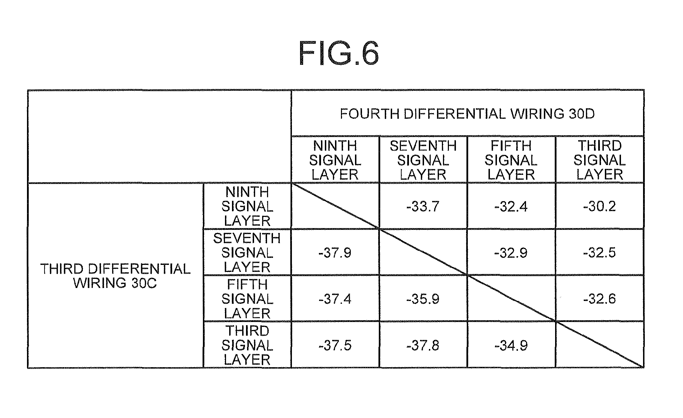

FIG. 6 is an explanatory view illustrating an example of a calculation result of crosstalk of Example 2. A first port P1 is a surface layer (an eighteenth signal layer) of the differential signal vias 12G, 12H of the first signal via pair 22A. A second port P2 is the terminal on the M1 side of the third differential wiring 30C connected to the differential signal vias 12G, 12H in the first signal via pair 22A, as illustrated in FIG. 4. A third port P3 is the line terminal on the M2 side of the fourth differential wiring 30D connected to the differential signal vias 12E, 12F in the second signal via pair 22B, as illustrated in FIG. 4. A fourth port P4 is the line terminal on the M1 side of the fourth differential wiring 30D as illustrated in FIG. 4.

The crosstalk would be different depending on in which of the plurality of signal layers 3 the third differential wiring 30C and the fourth differential wiring 30D are disposed. FIG. 6 is a list of crosstalks generated in the frequency band of 16 GHz when the third differential wiring 30C or the fourth differential wiring 30D is disposed in the third signal layer 3C, the fifth signal layer 3E, the seventh signal layer 3G or the ninth signal layer 3I. The crosstalk is small when the absolute value of thereof is large, and the crosstalk is large when the absolute value thereof is small.

For example, the crosstalk would be -32.6 dB when the third differential wiring 30C and the fourth differential wiring 30D are disposed in either the third signal layer 3C or the fifth signal layer 3E, the third differential wiring 30C in the fifth signal layer 3E and the fourth differential wiring 30D in the third signal layer 3C, for example. On the other hand, the crosstalk would be -34.9 dB when the third differential wiring 30C is disposed in the third signal layer 3C and the fourth differential wiring 30D is disposed in the fifth signal layer 3E, for example.

Therefore, the fourth differential wiring 30D connected to the differential signal via 12E (12F) of the second signal via pair 22B on the M2 side in the multilayer wiring board 1B is disposed in the signal layer 3 above the third differential wiring 30C connected to the differential signal via 12G (12H) of the first signal via pair 22A on the M1 side. As a result, the crosstalk can be reduced with the fourth differential wiring 30D being disposed in the signal layer 3 above the third differential wiring 30C.

In Example 2, the differential wiring 30 connected to the differential signal via 12 with a long stub passes between the differential signal vias 12 with relatively short stubs. For example, the fourth differential wiring 30D passes between the differential signal vias 12 with the relatively short stubs of the first signal via pair 22A on the front (M1: outer) side of the multilayer wiring board 1B, the fourth differential wiring 30D being connected to the differential signal via 12 with the relatively long stub of the second signal via pair 22B on the back (M2: inner) side. In short, the fourth differential wiring 30D is disposed in the signal layer above the third differential wiring 30C connected to the differential signal via 12 with the relatively short stub.

The third differential wiring 30C connected to the first signal via pair 22A, the differential signal via 12 of which has the relatively short stub, is disposed in the signal layer 3 below the fourth differential wiring 30D that receives the influence of the electromagnetic wave from the side of the second signal via pair 22B, the differential signal via 12 of which has the relatively long stub. As a result, the crosstalk can be reduced.

In Example 2, the pair of differential signal vias 12 in the signal via pair 22 is formed by the pair of vias 10 adjacent in the N1 or the N2 direction among the plurality of vias 10 disposed in the grid pattern at the predetermined pitch. However, the pair of differential signal vias 12 may also be formed by the pair of vias 10 adjacent in the M1 or the M2 direction.

Moreover, the specific numerical values in aforementioned Examples are given by way of example, but not limitation.

In one aspect, the crosstalk between the differential signal via and the differential wiring can be reduced.

## Claims

1. A multilayer wiring board (1A) comprising:
a plurality of signal layers (3);
a plurality of ground layers (2);
a first differential signal wiring (30A) wired to a first signal layer (3C) among the plurality of signal layers;
a second differential signal wiring (30B) wired to a second signal layer (3I) disposed above the first signal layer among the plurality of signal layers;
a first signal via (12A,21B) that extends in a laminating direction of the multilayer wiring board and is connected to the first differential signal wiring;
a second signal via (12B,21B) that is formed adjacent to the first signal via, extends in the laminating direction, and is connected to the first differential signal wiring;
a third signal via (12C,21A) that extends in the laminating direction and is connected to the second differential signal wiring, a stub of the third signal via being terminated above the first signal layer; and
a fourth signal via (12D,21A) that is formed adjacent to the third signal via, extends in the laminating direction, and is connected to the second differential signal wiring, a stub of the fourth signal via being terminated above the first signal layer, the first differential signal wiring being wired to pass between the fourth signal via and the third signal via.

2. A multilayer wiring board (1B) comprising:
a plurality of signal layers (3);
a plurality of ground layers (2);
a first differential signal wiring (30D) wired to a first signal layer (3I) among the plurality of signal layers;
a second differential signal wiring (30C) wired to a second signal layer (3C) disposed below the first signal layer among the plurality of signal layers;
a first signal via (12E,22B) that extends in a laminating direction of the multilayer wiring board and is connected to the first differential signal wiring;
a second signal via (12F,22B) that is formed adjacent to the first signal via, extends in the laminating direction, and is connected to the first differential signal wiring;
a third signal via (12G,22A) that extends in the laminating direction and is connected to the second differential signal wiring; and
a fourth signal via (12H,22A) that is formed adjacent to the third signal via, extends in the laminating direction, and is connected to the second differential signal wiring, the first differential signal wiring being wired to pass between the fourth signal via and the third signal via.

3. An electronic device comprising:
a multilayer wiring board (1A); and
a semiconductor component that is mounted on the multilayer wiring board,
wherein the multilayer wiring board includes:
a plurality of signal layers (3);
a plurality of ground layers (2);
a first differential signal wiring (30A) wired to a first signal layer (3C) among the plurality of signal layers;
a second differential signal wiring (30B) wired to a second signal layer (3I) disposed above the first signal layer among the plurality of signal layers;
a first signal via (12A,21B) that extends in a laminating direction of the multilayer wiring board and is connected to the first differential signal wiring;
a second signal via (12B,21B) that is formed adjacent to the first signal via, extends in the laminating direction, and is connected to the first differential signal wiring;
a third signal via (12C,21A) that extends in the laminating direction and is connected to the second differential signal wiring, a stub of the third signal via being terminated above the first signal layer; and
a fourth signal via (12D,21A) that is formed adjacent to the third signal via, extends in the laminating direction, and is connected to the second differential signal wiring, a stub of the fourth signal via being terminated above the first signal layer, the first differential signal wiring being wired to pass between the fourth signal via and the third signal via.

4. An electronic device comprising:
a multilayer wiring board (1B); and
a semiconductor component that is mounted on the multilayer wiring board,
wherein the multilayer wiring board includes:
a plurality of signal layers (3);
a plurality of ground layers (2);
a first differential signal wiring (30D) wired to a first signal layer (3I) among the plurality of signal layers;
a second differential signal wiring (30C) wired to a second signal layer (3C) disposed below the first signal layer among the plurality of signal layers;
a first signal via (12E,22B) that extends in a laminating direction of the multilayer wiring board and is connected to the first differential signal wiring;
a second signal via (12F,22B) that is formed adjacent to the first signal via, extends in the laminating direction, and is connected to the first differential signal wiring;
a third signal via (12G,22A) that extends in the laminating direction and is connected to the second differential signal wiring; and
a fourth signal via (12H,22A) that is formed adjacent to the third signal via, extends in the laminating direction, and is connected to the second differential signal wiring, the first differential signal wiring being wired to pass between the fourth signal via and the third signal via.
